# EUROPÄISCHE PATENTSCHRIFT

(11) **EP 4 172 840 B1**
(45) Veröffentlichungstag und Bekanntmachung des Hinweises auf die Patenterteilung: **18.06.2025**
(21) Anmeldenummer: 21737617.7
(22) Anmeldetag: 28.06.2021
(51) Int. Cl.: G06F 30/27

(54) **VERFAHREN ZUR STEUERUNG DER HERSTELLUNG EINES BLECHBAUTEILS UND VERFAHREN ZUM HERSTELLEN EINES BLECHBAUTEILS BZW. MEHRERER UNTERSCHIEDLICHER BLECHBAUTEILE**
METHOD FOR CONTROLLING THE PRODUCTION OF A SHEET METAL COMPONENT AND METHOD FOR MANUFACTURING A SHEET METAL COMPONENT OR SEVERAL DIFFERENT SHEET METAL COMPONENTS
PROCEDE DE CONTRÔLE DE LA PRODUCTION D'UN COMPOSANT EN TOLE ET PROCEDE DE PRODUCTION D'UN COMPOSANT EN TOLE OU DE PLUSIEURS COMPOSANTS EN TOLE DIFFERENTS

(30) Priorität: 30.06.2020 DE 102020208151
(43) Veröffentlichungstag der Anmeldung: 03.05.2023
(73) Patentinhaber: TRUMPF Werkzeugmaschinen SE + Co. KG, 71254 Ditzingen (DE)
(72) Erfinder: STEILING, Jonas, 71638 Ludwigsburg (DE)
(74) Vertreter: Trumpf Patentabteilung
(86) Internationale Anmeldenummer: PCT/EP2021/067730
(87) Internationale Veröffentlichungsnummer: WO 2022/002866

(56) Entgegenhaltungen:
- EP-A1- 3 316 156
- EP-A1- 3 657 446
- US-B1- 10 061 300

## Beschreibung

### Hintergrund der Erfindung

Die Erfindung betrifft ein Verfahren zur Steuerung der Herstellung eines Blechbauteils mit den Schritten
- Einlesen von CAD-Daten einer Ausgangskonstruktion des Blechbauteils,
- Parametrieren der CAD-Daten, sodass Parameterwerte der CAD-Daten erhalten werden.

Die Erfindung betrifft ferner ein Computerprogramm, umfassend Programmbefehle, die bei der Ausführung des Computerprogramms durch einen Computer diesen veranlassen ein solches Verfahren durchzuführen. Schließlich betrifft die Erfindung Verfahren zum Herstellen eines Blechbauteils bzw. mehrerer unterschiedlicher Blechbauteile.

Beim Konstruieren von Blechbauteilen ist in der Praxis oft nicht ersichtlich, inwiefern eine entworfene Konstruktion Optimierungspotential besitzt. Neben dem ursprünglichen Konstrukteur werden weitere Experten typischerweise nur zur Optimierung herangezogen, wenn das Blechbauteil in sehr großen Stückzahlen gefertigt werden soll.

Aus US 10,061,300 B1 ist ein Verfahren bekannt, bei dem eine Herstellanfrage ein digitales Modell eines physischen Objekts umfasst und von einem Computer erhalten wird, aus dem digitalen Modell ein Satz von Merkmalen des physischen Objekts bestimmt wird, ein Vorhersagewert für die Herstellanfrage anhand eines Regressions-Models des maschinellen Lernens und dem Satz von Merkmalen erzeugt wird, und eine nicht-deterministische Antwort auf Basis des Vorhersagewerts und eines Mehrkriterien-Optimierungsmodells bestimmt wird, wobei die nicht-deterministische Antwort einen Satz von Attributen eines Herstellprozesses des physischen Objekts enthält, und wobei der Satz von Attributen eine Mehrkriterien-Bedingung des Mehrkriterien-Optimierungsmodells erfüllt.

US 2020/0159886 A1 beschreibt ein Verfahren, bei welchem ein optimales Bauteil-Design erzeugt wird anhand einer Analyse einer Mehrzahl von ähnlichen Bauteil-Designs gemäß Zielvorgaben und Gewichtungen, die durch einen Benutzer vorgegeben werden.

### Aufgabe der Erfindung

Es ist eine Aufgabe der Erfindung, die effiziente Herstellung von Blechbauteilen zu ermöglichen.

### Beschreibung der Erfindung

Diese Aufgabe wird erfindungsgemäß gelöst durch ein Verfahren zum Herstellen einer Vielzahl von unterschiedlichen Blechbauteilen gemäß Anspruch 1, sowie durch ein Computerprogramm gemäß Anspruch 11.

Erfindungsgemäß ist ein computerimplementiertes Verfahren zur Steuerung der Herstellung eines Blechbauteils vorgesehen. Das Steuerungsverfahren weist folgende Schritte auf:
A) Einlesen von CAD-Daten einer Ausgangskonstruktion des Blechbauteils,
C) Parametrieren der CAD-Daten, sodass Parameterwerte der CAD-Daten erhalten werden,
D) Bewerten der Optimierbarkeit der Ausgangskonstruktion des Blechbauteils mittels einer künstlichen Intelligenz anhand der Parameterwerte der CAD-Daten und Ausgeben eines Bewertungsergebnisses.

Die Verfahrensschritte werden grundsätzlich in der angegebenen Reihenfolge durchgeführt.

Unter einem Blechbauteil wird insbesondere ein Bauteil verstanden, welches aus wenigstens einem Blech erhalten bzw. erhältlich ist. Blech bezeichnet dabei ein Halbzeug, dessen Dicke wesentlich geringer ist (typischerweise wenigstens um einen Faktor 10) als seine Ausdehnungen in zur Dickenrichtung orthogonalen Raumrichtungen. Das Blechbauteil kann insbesondere durch Biegen und Schweißen aus dem wenigstens einen Blech hergestellt sein. Es versteht sich, dass weitere Bearbeitungen an dem Blech bzw. Blechbauteil vorgenommen sein können.

Im Schritt A) werden CAD-Daten einer Ausgangskonstruktion des Blechbauteils in einen Speicher eines Computers eingelesen. Die Ausgangskonstruktion wurde zuvor typischerweise durch einen Konstrukteur erstellt. Alternativ kann die Ausgangskonstruktion automatisiert erstellt worden sein.

Vorzugsweise werden die CAD-Daten in dem Schritt A) als 3D-CAD-Daten eingelesen. In einem anschließenden Schritt B) werden diese 3D-CAD-Daten dann in 2D-CAD-Daten umgewandelt. Durch die Umwandlung kann ein für die nachfolgende Analyse geeignetes Datenformat erhalten werden.

Im Schritt C) werden Parameterwerte der CAD-Daten bestimmt. Hierzu können die CAD-Daten auf bestimmte Eigenschaften hin untersucht und Kennwerte für diese Eigenschaften ermittelt werden; diese Kennwerte bilden zumindest einige der Parameterwerte.

Die Parameterwerte können für Werkstückparameter bestimmt werden, vorzugsweise für einen oder mehrere der folgenden Parameter:
- Breite,
- Länge,
- Fläche,
- Dicke,
- Material,
- Rohmaterial,
- Verschnitt außen,
- Verschnitt innen,
- Gesamtlänge von Außenkonturen,
- Anzahl der Elemente der Außenkonturen,
- Typ der Elemente der Außenkonturen,
- Anzahl von Biegekanten,
- Anzahl von Konturen,
- Gesamtlänge von Innenkonturen,
- Gesamtlänge der Biegelinien,
- Biegung x Biegewinkel,
- Biegung x Typ,
- Biegung x Biegelänge,
- Biegung x Orientierung,
- Bereich der Orientierung der Biegungen,
- Anzahl der Schweißnähte,
- Schweißnahtlänge,
- Anzahl nichtlinearer Konturen.

Alternativ oder zusätzlich können die Parameterwerte für Ursprungsparameter bestimmt werden, vorzugsweise für einen Namen, insbesondere der beauftragenden Firma, des Konstrukteurs und/oder des Bauteils. Dadurch können Fähigkeiten und Erfahrungen eines Konstrukteurs oder einer Gruppe von Konstrukteuren, sowie der Zweck eines Bauteils (wenn der Dateiname oder Bauteilname Hinweise auf den Zweck gibt) durch die künstliche Intelligenz beachtet werden.

Weiter alternativ oder zusätzlich können die Parameterwerte für Metadaten bestimmt werden, vorzugsweise für einen oder mehrere der folgenden Parameter:
- Dateigröße,
- verwendete Konstruktionssoftware und/oder Konstruktionssoftwareversion. Diese Metadaten können einen Hinweis auf das Vorliegen oder Nichtvorliegen bestimmter typischer Fehlerbilder geben. Die Parameter für die Metadaten beziehen sich mithin indirekt auf Werkstückmerkmale.

Im Schritt D) wird die Optimierbarkeit der Ausgangskonstruktion des Blechbauteils mittels einer künstlichen Intelligenz anhand der Parameterwerte der CAD-Daten bewertet. Mit anderen Worten wird bestimmt, wie groß das Optimierungspotenzial der Ausgangskonstruktion ist. Hierzu werden die Parameterwerte mit der künstlichen Intelligenz analysiert. Dabei kann jeder einzelne im Schritt C) extrahierte Parameter, sowie die Zusammensetzung aller Parameter, analysiert werden. Ein Bewertungsergebnis wird ausgegeben. Das Bewertungsergebnis kann angezeigt werden, beispielsweise auf einem Bildschirm. Alternativ oder zusätzlich kann das Bewertungsergebnis in eine Datei geschrieben und/oder an ein vorzugsweise selbsttätig arbeitendes, Konstruktionssystem übermittelt werden. Das Bewertungsergebnis gibt typischerweise ein Maß der Optimierbarkeit an. Das Bewerten der Optimierbarkeit kann mit relativ geringem Rechenaufwand erfolgen. Demgegenüber erfordert ein im eingangs genannten Stand der Technik beschriebenes Durchführen der Optimierung einen erheblichen Aufwand. Das erfindungsgemäße Verfahren ermöglicht es, zur Optimierung verfügbare Ressourcen gezielt nur dann einzusetzen, wenn die Optimierung einen ausreichend großen Vorteil zu erzielen verspricht.

Die Optimierbarkeit kann durch einen Zahlenwert, insbesondere einen Prozentsatz, ausgedrückt werden, welcher angeben kann, inwieweit im Hinblick auf ein bestimmtes Kriterium Optimierungspotenzial besteht. Beispielsweise kann ausgegeben werden, dass die Schweißnahtlänge um voraussichtlich 50 % reduziert werden kann.

Vorteilhafterweise umfasst das Bewerten der Optimierbarkeit eine Einordnung in eine vorbestimmte Anzahl von, vorzugsweise drei, Kategorien. Die Kategorien können beispielsweise "hoch optimierbar", "optimierbar" und "nicht optimierbar" sein. Die Kategorie, in welche die Optimierbarkeit eingeordnet wurde, wird als das Bewertungsergebnis ausgegeben. Durch die Vorgabe weniger Kategorien kann eine gewisse - unvermeidliche - Unschärfe der Prognose der Optimierbarkeit überdeckt werden. Einem Anwender wird es durch die Kategorisierung erleichtert, für eine Optimierung vorzusehende Blechbauteile auszuwählen.

Die künstliche Intelligenz kann auf folgenden Modellen basieren: kNN, AdaBoost, Random Forest, vorzugsweise in der Variante Extra Trees, logistic regression, MLP/neuronales Netz, SVC und/oder Gaussian Processes. Die künstliche Intelligenz kann einen Algorithmus des maschinellen Lernens verwenden. Der Algorithmus des maschinellen Lernens kann mit gelabelten Daten, die Experten-Know-How beinhalten, trainiert worden sein. Hierfür können CAD-Dateien von Experten manuell bewertet und beispielsweise in die drei Kategorien "hoch optimierbar", "optimierbar" und "nicht optimierbar" unterteilt werden. Zum Trainieren des Algorithmus kann ein semi-supervised Lernverfahren eingesetzt werden. über eine Vielzahl von Daten lernt der Algorithmus, bei welcher Konstellation der Parameter ein Blechbauteil in welchem Maße optimierbar ist.

Vorteilhafterweise wird zum Bewerten im Schritt D) eine Konstellation der Parameterwerte zueinander ausgewertet. Unter der Konstellation werden insofern insbesondere Verhältnisse zweier oder mehrerer Parameterwerte zueinander und das Vorhandensein von Elementen bestimmter Art, beispielsweise von Schweißnähten, Biegungen oder Innenkonturen, verstanden. Das Auswerten der Konstellation der Parameterwerte kann es ermöglichen, optimierbare Teilaspekte des Blechbauteils identifizieren, beispielsweise eine Optimierbarkeit im Hinblick auf die Schweißnahtlänge oder die Anzahl und Länge von Biegungen.

In den Rahmen der vorliegenden Erfindung fällt ferner ein Computerprogramm umfassend Programmbefehle, die bei der Ausführung des Computerprogramms durch einen Computer diesen veranlassen, das oben beschriebene, erfindungsgemäße Verfahren durchzuführen.

Ferner fällt in den Rahmen der vorliegenden Erfindung ein Computerprogrammprodukt, auf dem ein solches Computerprogramm gespeichert ist. Unter einem Computerprogrammprodukt wird insofern ein computerlesbares Speichermedium verstanden, welches das Computerprogramm in computerlesbarer Form enthält.

Weiterhin in den Rahmen der vorliegenden Erfindung fällt ein Verfahren zum Herstellen eines Blechbauteils. Das Herstellverfahren weist folgende Schritte auf:
A) Einlesen von CAD-Daten einer Ausgangskonstruktion des Blechbauteils,
C) Parametrieren der CAD-Daten, sodass Parameterwerte der CAD-Daten erhalten werden,
D) Bewerten der Optimierbarkeit der Ausgangskonstruktion des Blechbauteils mittels einer künstlichen Intelligenz anhand der Parameterwerte der CAD-Daten und Ausgeben eines Bewertungsergebnisses,
F) Entwerfen einer optimierten Konstruktion des Blechbauteils, wenn das Bewertungsergebnis ein vorbestimmtes Maß der Optimierbarkeit erreicht oder übersteigt,
G) Festlegen einer Fertigkonstruktion des Blechbauteils, die der optimierten Konstruktion entspricht, sofern diese gemäß Schritt F) entworfen wurde, und die andernfalls der Ausgangskonstruktion entspricht,
H) Fertigen des Blechbauteils gemäß der Fertigkonstruktion.

Die Schritte A) bis D) entsprechen dem oben beschriebenen, erfindungsgemäßen Steuerungsverfahren. Für Vorteile und vorteilhafte Weiterbildungen dieser Schritte sei auf die obige Beschreibung verwiesen.

Wenn die Ausgangskonstruktion in einem ausreichenden Maße optimierbar ist, wird im Schritt F) eine optimierte Konstruktion des Blechbauteils entworfen. Das Entwerfen der optimierten Konstruktion kann manuell oder automatisch erfolgen.

Wenn aufgrund des zuvor bestimmten Maßes der Optimierbarkeit eine optimierte Konstruktion entworfen wurde, wird diese im Schritt G) als Fertigkonstruktion des Blechbauteils festgelegt. Andernfalls, d. h., wenn die Optimierbarkeit der Ausgangskonstruktion gemäß der Bewertung in Schritt D) das vorbestimmte Maß nicht erreicht, wird die Ausgangskonstruktion als die Fertigkonstruktion festgelegt. Es erfolgt somit nur dann eine aufwendige Optimierung der Konstruktion des Blechbauteils, wenn zu erwarten ist, dass hierdurch hinreichend große Vorteile erzielt werden können.

Die optimierte Konstruktion kann durch eine erneute Durchführung der Schritte A) bis D) auf ihre Optimierbarkeit hin überprüft werden, wobei die optimierte Konstruktion für den erneuten Durchlauf als die Ausgangskonstruktion betrachtet wird. Ggf. kann mehrfach eine optimierte Konstruktion entworfen werden, insbesondere bis deren Optimierbarkeit das vorbestimmte Maß unterschreitet.

Im abschließenden Schritt H) wird das Baublechbauteil gemäß der Fertigkonstruktion gefertigt. Das erfindungsgemäße Herstellverfahren liefert eine Abwägung zwischen einem einfachen Konstruktionsprozess ohne Iterationen (wenn die Ausgangskonstruktion kein oder nur wenig Optimierungspotenzial bietet) und einer verbesserten Herstellbarkeit des Blechbauteils gemäß der optimierten Konstruktion, wenn erkannt wurde, dass die Ausgangskonstruktion hinreichend viel Optimierungspotenzial aufweist. Der Einsatz der künstlichen Intelligenz zur Bewertung der Optimierbarkeit im Schritt D) ermöglicht hierbei ein zuverlässiges, schnelles und ressourcenschonendes Vorgehen.

Schließlich fällt ein Verfahren zum Herstellen einer Vielzahl von unterschiedlichen Blechbauteilen in den Rahmen der vorliegenden Erfindung. Das Herstellverfahren für die vielen unterschiedlichen Blechbauteile weist folgende Schritte auf:
A) Einlesen von CAD-Daten einer Ausgangskonstruktion des jeweiligen Blechbauteils,
C) Parametrieren der CAD-Daten, sodass Parameterwerte der CAD-Daten erhalten werden,
D) Bewerten der Optimierbarkeit der Ausgangskonstruktion des jeweiligen Blechbauteils mittels einer künstlichen Intelligenz anhand der Parameterwerte der CAD-Daten und Ausgeben eines Bewertungsergebnisses.

Die Schritte A) bis D) entsprechen dem oben beschriebenen, erfindungsgemäßen Steuerungsverfahren, welches hier für jedes der unterschiedlichen Blechbauteile durchgeführt wird. Für Vorteile und vorteilhafte Weiterbildungen dieser Schritte sei auf die obige Beschreibung verwiesen.

Das Herstellverfahren für die vielen unterschiedlichen Blechbauteile weist weiterhin folgende Schritte auf:
e) Auswählen von denjenigen Blechbauteilen, für die das Bewertungsergebnis ein vorbestimmtes Maß der Optimierbarkeit erreicht oder übersteigt, zur Optimierung ihrer jeweiligen Konstruktion,
f) Entwerfen einer optimierten Konstruktion der im Schritt e) ausgewählten Blechbauteile,
g) Festlegen einer Fertigkonstruktion für jedes der unterschiedlichen Blechbauteile, wobei die Fertigkonstruktion für die im Schritt e) ausgewählten Blechbauteile der optimierten Konstruktion entspricht und für die im Schritt e) nicht ausgewählten Blechbauteile der jeweiligen Ausgangskonstruktion entspricht,
h) Fertigen je wenigstens eines Exemplars der unterschiedlichen Blechbauteile.

Im Schritt e) werden diejenigen Blechbauteile für eine Optimierung ausgewählt, bei denen durch ein Optimieren der Konstruktion hinreichend große Vorteile zu erwarten sind. Hierbei kann berücksichtigt werden, wie viele Exemplare des jeweiligen Blechbauteils gefertigt werden sollen. Insbesondere können bei größeren zu fertigenden Stückzahlen geringere Optimierungsvorteile den Aufwand der Optimierung rechtfertigen. Wenn beim Bewerten der Optimierbarkeit eine Einordnung in eine vorbestimmte Anzahl von Kategorien erfolgt, kann vorgesehen sein, dass die Grenzen der Kategorien in Abhängigkeit von der von einem jeweiligen Blechbauteil zu fertigende Stückzahl definiert sind.

Für die zuvor ausgewählten Blechbauteile wird im Schritt f) jeweils eine optimierte Konstruktion entworfen. Das Entwerfen der optimierten Konstruktionen kann manuell oder automatisch erfolgen.

Wenn aufgrund des zuvor bestimmten Maßes der Optimierbarkeit eine optimierte Konstruktion für eines der Blechbauteile entworfen wurde, wird diese im Schritt g) als Fertigkonstruktion des jeweiligen Blechbauteils festgelegt. Andernfalls, d. h., wenn die Optimierbarkeit der Ausgangskonstruktion gemäß der Bewertung im Schritt D) das vorbestimmte Maß nicht erreicht, wird die Ausgangskonstruktion als die Fertigkonstruktion des jeweiligen Blechbauteils festgelegt. Es erfolgt somit nur bei denjenigen Blechbauteilen eine aufwendige Optimierung ihrer Konstruktion, bei denen zu erwarten ist, dass hierdurch hinreichend große Vorteile erzielt werden können.

Im abschließenden Schritt h) wird von jedem Blechbauteil wenigstens ein Exemplar gemäß der jeweiligen Fertigkonstruktion gefertigt. Das erfindungsgemäße Herstellverfahren liefert eine Abwägung zwischen einem einfachen Konstruktionsprozess ohne Iterationen (bei denjenigen Blechbauteilen, deren Ausgangskonstruktionen nur wenig Optimierungspotenzial bieten) und einer verbesserten Herstellbarkeit der Blechbauteile gemäß den optimierten Konstruktionen, wenn erkannt wurde, dass die Ausgangskonstruktionen hinreichend viel Optimierungspotenzial aufweisen. Der Einsatz der künstlichen Intelligenz zur Bewertung der Optimierbarkeit im Schritt D) ermöglicht hierbei ein zuverlässiges, schnelles und ressourcenschonendes Vorgehen.

Es kann vorgesehen sein, dass nach der Durchführung von Schritt f) für die ausgewählten Blechbauteile die Schritte A) bis f) wiederholt werden, wobei für die erneute Durchführung dieser Schritte jeweils die optimierte Konstruktion als die Ausgangskonstruktion verwendet wird. Auf diese Weise können die Konstruktionen der zuvor für eine Optimierung ausgewählten Blechbauteile weiter verbessert werden. Vorzugsweise werden die Schritte A) bis f) für die jeweils ausgewählten Blechbauteile wiederholt, bis bei der Durchführung von Schritt e) kein Blechbauteil mehr ausgewählt wird. Derart kann erreicht werden, dass für jedes der unterschiedlichen Blechbauteile eine zumindest nahezu optimale Konstruktion vorliegt. Bei dieser Variante erfolgt zugunsten einer verbesserten Herstellbarkeit ein erhöhter Ressourceneinsatz für den Entwurf von Konstruktionen und deren Überprüfung.

Weitere Merkmale und Vorteile der Erfindung ergeben sich aus der Beschreibung und der Zeichnung. Erfindungsgemäß können die vorstehend genannten und die noch weiter ausgeführten Merkmale jeweils einzeln für sich oder zu mehreren in beliebigen, zweckmäßigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:

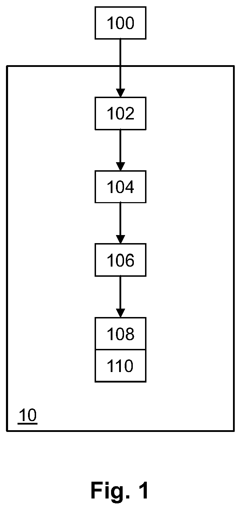

- Fig. 1: ein schematisches Ablaufdiagramm eines erfindungsgemäßen Verfahrens zur Steuerung der Herstellung eines Blechbauteils, bei dem mit einer künstlichen Intelligenz die Optimierbarkeit einer Ausgangskonstruktion des Blechbauteils anhand von Parameterwerten, die aus CAD-Daten der Ausgangskonstruktion extrahiert werden, ermittelt wird;

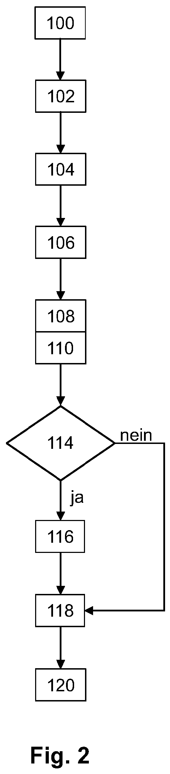

- Fig. 2: ein schematisches Ablaufdiagramm eines erfindungsgemäßen Verfahrens zum Herstellen eines Blechbauteils, wobei vor dem Fertigen des Blechbauteils die Optimierbarkeit von dessen Ausgangskonstruktion durch eine künstliche Intelligenz beurteilt wird und bei hinreichend großer Optimierbarkeit eine optimierte Konstruktion entworfen wird;

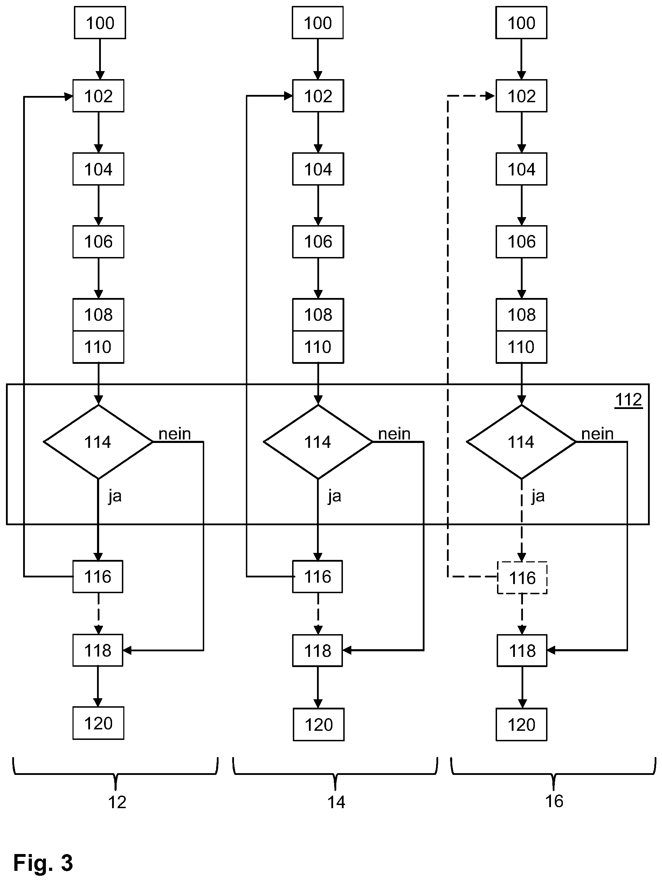

- Fig. 3: ein schematisches Ablaufdiagramm eines erfindungsgemäßen Verfahrens zum Herstellen einer Vielzahl von unterschiedlichen Blechbauteilen, wobei vor dem Fertigen der Blechbauteile die Optimierbarkeit von deren jeweiliger Ausgangskonstruktion durch eine künstliche Intelligenz beurteilt wird und bei hinreichend großer Optimierbarkeit eine optimierte Konstruktion für die entsprechenden Blechbauteile entworfen wird.

**Figur 1** zeigt ein Ablaufdiagramm eines computerimplementierten Verfahrens zur Steuerung der Herstellung eines Blechbauteils. Zunächst wird eine Ausgangskonstruktion des Blechbauteils in einem Schritt **100** in Form von CAD-Daten bereitgestellt. Die CAD-Daten der Ausgangskonstruktion werden in einem Schritt **102** in einen Speicher eines Computers, auf dem das Verfahren abläuft, eingelesen. Vorzugsweise werden die CAD-Daten als 3D-CAD-Daten bereitgestellt und eingelesen, beispielsweise im Format .step. Die eingelesenen 3D-CAD-Daten können einem Schritt **104** in 2D-CAD-Daten umgewandelt werden, beispielsweise in das Format .geo. Wenn die CAD-Daten der Ausgangskonstruktion bereits als 2D-CAD-Daten bereitgestellt und eingelesen werden, kann der Schritt des Umwandelns in 2D-CAD-Daten entfallen. Alternativ kann das Verfahren auch mit 3D-CAD-Daten durchgeführt werden.

Die eingelesenen und gegebenenfalls umgewandelten CAD-Daten der Ausgangskonstruktion werden in einem Schritt **106** parametriert, sodass Parameterwerte der CAD-Daten erhalten werden. Die Parameterwerte können einen oder mehrere der folgenden Parameter der Ausgangskonstruktion kennzeichnen:
- Name,
- Breite,
- Länge,
- Fläche,
- Dicke,
- Material,
- Rohmaterial,
- Verschnitt außen,
- Verschnitt innen,
- Dateigröße,
- Gesamtlänge von Außenkonturen,
- Anzahl von Elementen der Außenkonturen,
- Typ der Elemente der Außenkonturen,
- Anzahl von Biegekanten,
- Anzahl von Konturen,
- Gesamtlänge von Innenkonturen,
- Gesamtlänge der Biegelinien,
- Biegung x Biegewinkel,
- Biegung x Typ,
- Biegung x Biegelänge,
- Biegung x Orientierung,
- Bereich der Orientierung der Biegungen,
- Anzahl der Schweißnähte,
- Schweißnahtlänge,
- Anzahl nichtlinearer Konturen.

Sodann wird in einem Schritt **108** die Optimierbarkeit der Ausgangskonstruktion anhand der zuvor ermittelten Parameterwerte durch eine künstliche Intelligenz bewertet. Zum Bewerten der Optimierbarkeit kann die künstliche Intelligenz insbesondere eine Zusammensetzung (Konstellation) der Parameter auswerten. Die künstliche Intelligenz kann ein neuronales Netz sein, welches in einem semi-supervised-Lernverfahren anhand von Beispiel-Blechbauteilen, deren Optimierbarkeit von Experten bewertet wurde, trainiert worden ist. Vorzugsweise erfolgt die Bewertung, indem die Optimierbarkeit der Ausgangskonstruktion in eine von mehreren vordefinierten Kategorien (Klassen) der Optimierbarkeit eingeteilt wird. Vorzugsweise werden drei Kategorien betrachtet. Die Ausgangskonstruktion kann beispielsweise in die Kategorien "hoch optimierbar", "optimierbar" und "nicht optimierbar" eingeteilt werden.

Das Bewertungsergebnis aus Schritt 108 wird in einem Schritt **110** ausgegeben. Das Ausgeben kann durch Anzeigen auf einem Bildschirm erfolgen. Alternativ oder zusätzlich kann das Bewertungsergebnis in eine Datei geschrieben werden. Insbesondere kann eine CAD-Datei der Ausgangskonstruktion mit dem Maß der Optimierbarkeit als zusätzlichem Attribut versehen werden.

Die Schritte 102 bis 110 werden durch ein auf einem Computer ablaufendes Computerprogramm ausgeführt. Das Computerprogramm umfasst Programmbefehle, die den Computer dazu veranlassen, bei der Ausführung des Computerprogramms die Schritte 102 bis 110 durchzuführen. Das Computerprogramm mit den Programmbefehlen kann auf einem Computerprogrammprodukt **10** gespeichert sein. Das Computerprogrammprodukt 10 kann beispielsweise eine Speicherkarte oder eine Festplatte sein. Das Computerprogramm kann über das Internet herunterladbar sein. Vorzugsweise kann die Ausführung des Computerprogramms über das Internet gestartet werden. Insbesondere kann vorgesehen sein, dass das Computerprogramm auf einem Server abläuft, der die CAD-Daten der Ausgangskonstruktion von einem Anwender-PC einliest. In diesem Fall wird das Bewertungsergebnis im Schritt 110 typischerweise an den Anwender-PC zurück übermittelt und kann über diesen und/oder dessen Peripheriegeräte weiterverbreitet, insbesondere angezeigt, werden.

**Figur 2** zeigt ein Ablaufdiagramm eines Verfahrens zum Herstellen eines Blechbauteils unter Verwendung des Steuerungsverfahrens von Figur 1. Bei dem Herstellverfahren werden zunächst die oben beschriebenen Schritte 100 bis 110 durchgeführt. Das hierbei erhaltene Bewertungsergebnis wird in einem Schritt **114** daraufhin überprüft, ob die Optimierbarkeit der Ausgangskonstruktion ein vorbestimmtes Maß der Optimierbarkeit erreicht oder übersteigt. Wenn dies der Fall ist, wird in einem Schritt **116** eine optimierte Konstruktion für das Blechbauteil entworfen. Die optimierte Konstruktion kann sodann in einem Schritt **118** als eine Fertigkonstruktion des Blechbauteils festgelegt werden. Wenn die Bewertung der Ausgangskonstruktion ergeben hat, dass diese nicht in einem ausreichenden Maße optimierbar ist, wird in dem Schritt 118 die Ausgangskonstruktion als die Fertigkonstruktion des Blechbauteils festgelegt. In einem abschließenden Schritt **120** wird das Blechbauteil gemäß der zuvor festgelegten Fertigkonstruktion hergestellt.

**Figur 3** zeigt ein Ablaufdiagramm eines Verfahrens zum Herstellen mehrerer verschiedener Blechbauteile. In Figur 3 ist das Verfahren beispielhaft für drei unterschiedliche Blechbauteile dargestellt. Das Verfahren beruht auf der zumindest teilweise zeitlich überlappenden Durchführung der zuvor beschriebenen Schritte 102 bis 118 in Verfahrenssträngen **12, 14** und **16** für jedes der unterschiedlichen Blechbauteile.

Nach der Durchführung der Schritte 100 bis 110 für die unterschiedlichen Blechbauteile werden in einem Schritt **112** anhand der jeweiligen Abfragen 114 diejenigen Blechbauteile für eine Optimierung ihrer Konstruktion ausgewählt, bei denen ein hinreichend hoher Grad der Optimierbarkeit festgestellt wurde. Beim Festlegen des hierfür anzusetzenden Grades der Optimierbarkeit kann berücksichtigt werden, wie viele Exemplare des jeweiligen Blechbauteils gefertigt werden sollen. Der Schritt 112 erfolgt vorzugsweise zugleich für alle im Rahmen des Verfahrens herzustellenden unterschiedlichen Blechbauteile.

Für die nicht ausgewählten Blechbauteile (hier beispielhaft im Verfahrensstrang 16 dargestellt) wird die Ausgangskonstruktion in einem jeweiligen Schritt 118 als die Fertigkonstruktion festgelegt. Für die ausgewählten Blechbauteile (hier beispielhaft bei den Verfahrenssträngen 12 und 14 dargestellt) wird in einem jeweiligen Schritt 116 jeweils eine optimierte Konstruktion entworfen. Es kann vorgesehen sein, dass die optimierte Konstruktion wie zuvor bei Figur 2 beschrieben, als die Fertigkonstruktion festgelegt wird, vergleiche gestrichelte Pfeile zwischen den Schritten 116 und 118 in Figur 3. Alternativ kann vorgesehen sein, dass die optimierte Konstruktion durch eine erneute Durchführung der Schritte 102 bis 110 auf ihre Optimierbarkeit hin untersucht wird, wobei die optimierte Konstruktion beim erneuten Durchlauf als die Ausgangskonstruktion betrachtet wird, vergleiche Rückführungspfeile von den Schritten 116 zu den Schritten 102. Hierbei kann vorgesehen sein, dass jeweils so oft eine optimierte Konstruktion entworfen wird, bis bei den Schritten 112 und 114 keines der Blechbauteile mehr für eine Optimierung ausgewählt wird. Alternativ kann die Anzahl der Optimierungsschleifen auf einen vorbestimmten Wert begrenzt sein. Die optimierte Konstruktion wird schließlich in einem jeweiligen Schritt 118 als die Fertigkonstruktion für das jeweilige Blechbauteil festgelegt. Es versteht sich, dass die iterative Optimierung der Konstruktion des Blechbauteils auch bei dem Verfahren zur Fertigung eines (einzigen) Blechbauteils gemäß Figur 2 vorgesehen sein kann.

Nach Festlegen der jeweiligen Fertigkonstruktion wird von jedem der unterschiedlichen Blechbauteile je wenigstens ein Exemplar in einem jeweiligen Schritt 120 hergestellt.

### Bezugszeichenliste

Computerprogrammprodukt **10**
Verfahrensstränge **12, 14, 16**
Bereitstellen **100** von CAD-Daten einer Ausgangskonstruktion
Einlesen **102** der CAD-Daten
Umwandeln **104** der CAD-Daten
Parametrieren **106** der CAD-Daten
Bewerten **108** der Optimierbarkeit
Ausgeben **110** eines Bewertungsergebnisses
Auswählen **112** von Blechbauteilen
Abfrage **114:** Erreicht/übersteigt die Optimierbarkeit ein vorbestimmtes Maß?
Entwerfen **116** einer optimierten Konstruktion
Festlegen **118** einer Fertigkonstruktion
Fertigen **120** des Blechbauteils

## Patentansprüche

1. Verfahren zum Herstellen einer Vielzahl von unterschiedlichen Blechbauteilen,
wobei das Verfahren für jedes der unterschiedlichen Blechbauteile folgende Schritte aufweist:
A) Einlesen (102) von CAD-Daten einer Ausgangskonstruktion des jeweiligen Blechbauteils,
C) Parametrieren (106) der CAD-Daten, sodass Parameterwerte für einen oder mehrere der Werkstückparameter der CAD-Daten erhalten werden,
D) Bewerten (108) der Optimierbarkeit der Ausgangskonstruktion des jeweiligen Blechbauteils bezüglich einer Schweißnahtlänge oder einer Anzahl und Länge von Biegungen mittels einer künstlichen Intelligenz anhand der Parameterwerte der CAD-Daten und Ausgeben (110) eines Bewertungsergebnisses,
und wobei das Verfahren weiterhin folgende Schritte aufweist:
e) Auswählen (112) von denjenigen Blechbauteilen, für die das Bewertungsergebnis ein vorbestimmtes Maß der Optimierbarkeit erreicht oder übersteigt, zur Optimierung ihrer jeweiligen Konstruktion,
f) Entwerfen (116) einer optimierten Konstruktion der im Schritt e) ausgewählten Blechbauteile,
g) Festlegen (118) einer Fertigkonstruktion für jedes der unterschiedlichen Blechbauteile, wobei die Fertigkonstruktion für die im Schritt e) nicht ausgewählten Blechbauteile der jeweiligen Ausgangskonstruktion entspricht und wobei die Fertigkonstruktion für die im Schritt e) ausgewählten Blechbauteile der optimierten Konstruktion entspricht,
h) Fertigen (120) je wenigstens eines Exemplars der unterschiedlichen Blechbauteile gemäß der Fertigkonstruktion.

2. Verfahren nach Anspruch 1, **dadurch gekennzeichnet, dass** bei der Auswahl der Blechbauteile im Schritt e) berücksichtigt wird, wie viele Exemplare des jeweiligen Blechbauteils gefertigt werden sollen.

3. Verfahren nach Anspruch 1 oder 2, **dadurch gekennzeichnet, dass** nach der Durchführung von Schritt f) für die ausgewählten Blechbauteile die Schritte A) bis f) wiederholt werden, wobei für die erneute Durchführung dieser Schritte jeweils die optimierte Konstruktion als die Ausgangskonstruktion verwendet wird.

4. Verfahren nach Anspruch 3, **dadurch gekennzeichnet, dass** die Schritte A) bis f) für die jeweils ausgewählten Blechbauteile wiederholt werden, bis bei der Durchführung von Schritt e) kein Blechbauteil mehr ausgewählt wird.

5. Verfahren nach einem der Ansprüche 1 bis 4 **dadurch gekennzeichnet, dass** die CAD-Daten in dem Schritt A) als 3D-CAD-Daten eingelesen werden und in einem Schritt B) in 2D-CAD-Daten umgewandelt (104) werden.

6. Verfahren nach einem der Ansprüche 1 bis 5, **dadurch gekennzeichnet, dass** im Schritt C) Parameterwerte für Ursprungsparameter bestimmt werden, vorzugsweise für einen Namen, insbesondere der beauftragenden Firma, des Konstrukteurs und/oder des Bauteils.

7. Verfahren nach einem der Ansprüche 1 bis 6, **dadurch gekennzeichnet, dass** im Schritt C) Parameterwerte für Metadaten bestimmt werden, vorzugsweise für einen oder mehrere der folgenden Parameter:
- Dateigröße,
- verwendete Konstruktionssoftware und/oder
Konstruktionssoftwareversion.

8. Verfahren nach einem der Ansprüche 1 bis 7, **dadurch gekennzeichnet, dass** im Schritt D) das Bewerten der Optimierbarkeit eine Einordnung in eine vorbestimmte Anzahl von, vorzugsweise drei, Kategorien umfasst.

9. Verfahren nach einem der Ansprüche 1 bis 8, **dadurch gekennzeichnet, dass** die künstliche Intelligenz einen Algorithmus des maschinellen Lernens verwendet.

10. Verfahren nach einem der Ansprüche 1 bis 9, **dadurch gekennzeichnet, dass** zum Bewerten im Schritt D) eine Konstellation der Parameterwerte zueinander ausgewertet wird.

11. Computerprogramm umfassend Programmbefehle, die bei der Ausführung des Computerprogramms durch einen Computer diesen veranlassen, das Verfahren nach einem der Ansprüche 1 bis 10 durchzuführen.

## Claims

1. A method for producing a plurality of different sheet metal components,
wherein the method comprises the following steps for each of the different sheet metal components:
A) importing (102) CAD data of an initial design of the respective sheet metal component,
C) parameterising (106) the CAD data so as to obtain parameter values for one or more of the workpiece parameters of the CAD data,
D) evaluating (108) the optimisability of the initial design of the respective sheet metal component with regard to a weld length or a number and length of bends by means of artificial intelligence based on the parameter values of the CAD data and outputting (110) an evaluation result,
and wherein the method further comprises the following steps:
e) selecting (112) those sheet metal components for which the evaluation result has reached or exceeded a predetermined degree of optimisability, in order to optimise their respective design,
f) drafting (116) an optimised design of the sheet metal components selected in step e),
g) determining (118) a final design for each of the different sheet metal components, wherein the final design for the sheet metal components not selected in step e) corresponds to the respective initial design and wherein the final design for the sheet metal components selected in step e) corresponds to the optimised design,
h) manufacturing (120) at least one copy of each of the different sheet metal components in accordance with the final design.

2. The method according to claim 1, **characterised in that** when selecting the sheet metal components in step e), the number of copies of the respective sheet metal component to be manufactured is taken into account.

3. The method according to claim 1 or 2, **characterised in that** after step f) has been carried out for the selected sheet metal components, steps A) to f) are repeated, wherein the optimised design is used as the initial design for the renewed execution of these steps.

4. The method according to claim 3, **characterised in that** steps A) to f) are repeated for the respective selected sheet metal components until no more sheet metal components are selected when step e) is carried out.

5. The method according to any one of claims 1 to 4, **characterised in that** the CAD data are imported as 3D CAD data in step A) and are converted (104) into 2D CAD data in step B).

6. The method according to any one of claims 1 to 5, **characterised in that** in step C) parameter values are determined for original parameters, preferably for a name, in particular of the commissioning company, the designer and/or the component.

7. The method according to any one of claims 1 to 6, **characterised in that** parameter values for metadata are determined in step C), preferably for one or more of the following parameters:
- file size,
- design software and/or design software version used.

8. The method according to any one of claims 1 to 7, **characterised in that** in step D) the evaluation of the optimisability comprises a classification into a predetermined number of, preferably three, categories.

9. The method according to any one of claims 1 to 8, **characterised in that** the artificial intelligence uses a machine learning algorithm.

10. The method according to any one of claims 1 to 9, **characterised in that** a constellation of the parameter values relative to one another is evaluated for the evaluation in step D).

11. A computer program comprising program commands that, when the computer program is executed by a computer, cause the computer to carry out the method according to one of claims 1 to 10.

## Revendications

1. Procédé de fabrication d'une pluralité de différents composants en tôle,
dans lequel le procédé comprend les étapes suivantes pour chacun des différents composants en tôle :
A) lecture (102) des données CAO d'une conception initiale du composant en tôle respectif,
C) paramétrage (106) des données CAO de sorte que des valeurs de paramètre pour un ou plusieurs des paramètres de pièce des données CAO soient obtenues,
D) évaluation (108) du potentiel d'optimisation de la conception initiale du composant en tôle respectif concernant une longueur de cordon de soudure ou un nombre et une longueur de plis au moyen d'une intelligence artificielle sur la base des valeurs de paramètre des données CAO, et fourniture (110) d'un résultat d'évaluation,
et dans lequel le procédé comprend en outre les étapes suivantes :
e) sélection (112) des composants en tôle pour lesquels le résultat d'évaluation atteint ou dépasse un degré de potentiel d'optimisation prédéterminé, afin d'optimiser leur conception respective,
f) préparation (116) d'une conception optimisée des composants en tôle sélectionnés à l'étape e),
g) détermination (118) d'une conception finalisée pour chacun des différents composants en tôle, dans lequel la conception finalisée pour les composants en tôle non sélectionnés à l'étape e) correspond à la conception initiale respective, et dans lequel la conception finalisée pour les composants en tôle sélectionnés à l'étape e) correspond à la conception optimisée,
h) fabrication (120) d'au moins un exemplaire de chacun des différents composants en tôle selon la conception finalisée.

2. Procédé selon la revendication 1, **caractérisé en ce que**, lors de la sélection des composants en tôle à l'étape e), le nombre d'exemplaires du composant en tôle respectif à fabriquer est pris en compte.

3. Procédé selon la revendication 1 ou 2, **caractérisé en ce qu'**après l'exécution de l'étape f) pour les composants en tôle sélectionnés, les étapes A) à f) sont répétées, dans lequel la conception optimisée est utilisée comme conception initiale pour la nouvelle exécution de ces étapes.

4. Procédé selon la revendication 3, **caractérisé en ce que** les étapes A) à f) sont répétées pour les composants en tôle sélectionnés respectifs jusqu'à ce qu'aucun autre composant en tôle ne soit sélectionné lors de l'exécution de l'étape e).

5. Procédé selon l'une des revendications 1 à 4, **caractérisé en ce que** les données CAO sont lues en tant que données CAO 3D à l'étape A) et sont converties (104) en données CAO 2D à l'étape B).

6. Procédé selon l'une des revendications 1 à 5, **caractérisé en ce qu'**à l'étape C) des valeurs de paramètre pour des paramètres d'origine sont déterminées, de préférence pour un nom, en particulier de l'entreprise commanditaire, du concepteur et/ou du composant.

7. Procédé selon l'une des revendications 1 à 6, **caractérisé en ce qu'**à l'étape C) des valeurs de paramètre sont déterminées pour les métadonnées, de préférence pour un ou plusieurs des paramètres suivants :
- taille du fichier,
- logiciel de conception et/ou version du logiciel de conception utilisé.

8. Procédé selon l'une des revendications 1 à 7, **caractérisé en ce qu'**à l'étape D) l'évaluation du potentiel d'optimisation comprend une classification en un nombre prédéterminé de catégories, et de préférence en trois catégories.

9. Procédé selon l'une des revendications 1 à 8, **caractérisé en ce que** l'intelligence artificielle utilise un algorithme d'apprentissage automatique.

10. Procédé selon l'une des revendications 1 à 9, **caractérisé en ce que** pour l'évaluation à l'étape D), les valeurs d'une constellation des valeurs de paramètre sont évaluées les unes par rapport aux autres.

11. Programme informatique comprenant des instructions de programme qui, quand le programme informatique est exécuté par un ordinateur, commandent à l'ordinateur de mettre en œuvre le procédé selon l'une des revendications 1 à 10.
